# EUROPEAN PATENT APPLICATION

(11) **EP 4 704 259 A1**
(43) Date of publication of application: **04.03.2026**
(21) Application number: 25194601.8
(22) Date of filing: 07.08.2025
(51) Int. Cl.: H01R 13/52, H01R 13/533, F04B 39/12, F04B 39/00, F04B 35/04

(54) **ELECTRICAL FEEDTHROUGH ASSEMBLY**

(30) Priority: 03.09.2024 EP 24198056
(71) Applicant: SCHOTT AG, 55122 Mainz (DE)
(72) Inventor: HARTL, Helmut, 3400 Weidling (AT)
(74) Representative: Schott Corporate IP

(57) **Abstract**

An electrical feedthrough assembly (1) suitable for an e-compressor is provided, comprising a base body (10) configured for attachment to a housing and comprising at least one electrical feedthrough (2), each electrical feed-through (2) comprising an opening (14) in the base body (10) for a conductor (12) which is fed through the opening (14) and embedded in a fixation material (16) which seals the opening (14) of the electrical feedthrough (2), wherein the electrical feedthrough assembly (1) further comprises at least one insulation element (20, 20') made from rubber being affixed to the base body (10) by means of an electrically insulating adhesive material (40). The at least one insulation element (20, 20') comprises at least one insulation section (22), each insulation section (22) having a conductor opening (24) having an inner wall (25), wherein the respective conductor (12) is fed through the conductor opening (24). The insulation element (20, 20') being configured and arranged such that a cavity (23) extending along the conductor (12) is formed between the insulation section (22) and the conductor (12) and such that between the inner wall (25) of the conductor opening (24) and the surface of the conductor (12) at least one gap (27') in form of at least one groove (27) is formed allowing access from the cavity (23) to the environment, the cavity (23) being at least partially filled with the adhesive material (40) for affixing the insulation section (22). The inner wall (25) outside the at least one groove (27) touches the respective conductor surface for positioning and providing a seal.

## Description

The invention relates to an electrical feedthrough assembly which is preferably configured as e-compressor terminal, and which comprises at least one electrical feedthrough, each electrical feedthrough comprising an opening in the base body for a conductor which is fed through the opening and embedded in a fixation material which seals the opening of the electrical feedthrough, wherein the electrical feedthrough assembly further comprises at least one insulation element being affixed to the base body by means of an adhesive material.

Housings for electronic components usually require a plurality of electrical feedthroughs in order to enable electrical connections from outside to the inner part of the housing, which accommodates e.g. parts of an electronic compressor in the housing. The electrical feedthroughs should be fluid tight or even hermetic in order to protect the components inside the housing from the environment and/or to contain gases or fluids in the housing. In order to provide such fluid-tight or hermetic feedthroughs for an electric conductor arranged in an opening of the housing, glass-to-metal seals may be used. A fixation material, for example a glass material, is used to seal the opening and to hold the conductor within the opening. The fixation material also provides an electrical insulation between the conductor and the housing.

To provide additional electrical insulation between the housing and the conductor and, if more than one conductor is present between the conductors, it is known to arrange an additional insulation element on the electrical feedthrough. The insulation element at least partially surrounds the conductor and enlarges a so-called creepage distance between a conductor and the housing and/or between two conductors. The insulation element for extending the creepage distance may be, for example, an insulating rubber or plastic sleeve or cylinder, which at least partially surrounds a conductor.

WO2022259597A1 describes an airtight terminal having a metal base body which has at least one opening. A connecting lead is inserted through the opening and a fixation material seals said opening. The terminal further comprises an insulating cylinder having at least one peripheral groove on the outer periphery wall. The insulating cylinder is made from a heat-resistant and oil/refrigerant-resistant elastic rubber or plastic material and which is airtightly adhered to the fixation material or the base body via an adhesive layer. Suitable plastic materials for the insulating cylinder include PBT (polybutylene terephthalate), PPS (polyphenylene sulfide), or PEEK (polyetheretherketone). Suitable rubber materials include HNBR (hydrogenated nitrile rubber) or EPDM (ethylene-propylene-diene rubber). For bonding insulating cylinders made from PPS and EPDM an epoxy adhesive is used.

US 4984973 relates to hermetic compressors of the type having a hermetic housing, wherein a hermetic terminal is provided for carrying electric current into the housing. The terminal provides an electrically insulating distance between the current-conducting pins and the metallic body member of the hermetic terminal. This is achieved by electrically insulating cap members adhered to the outer surface of the metallic body member by means of a thin uniform layer of an electrically insulating adhesive.

However, it is difficult to reliably apply the correct amount of adhesive such that the insulating element is securely attached without any bubbles or gaps in the glue and without excess glue overflowing onto other parts of the feedthrough. Overflowing glue may block parts of the feedthrough assembly required for mounting to a housing or may cover parts of the conductor which are intended to make electrical contact, for example with a connector. Further, any gaps or bubbles may negatively affect the insulating properties of the insulator and may allow dirt or water to damage the connection.

Further, the diameter of the insulation element's conductor opening through which the conductor is fed is chosen to be small so that the insulation element presses against the conductor for sealing purpose. However, there is the risk that moisture is penetrating between conductor and insulation element, which reduces the insulation resistance of the feedthrough.

It is an object of the present invention to provide a feedthrough assembly having at least one sealed conductor and an additional insulation element for extending of a creeping distance between the conductor and a base body of the feedthrough, which is easy to manufacture and allows for a reliable connection of the insulation element providing increased insulation resistance.

### Disclosure of the invention

An electrical feedthrough assembly is provided which comprises a base body configured for attachment to a housing and comprising one or more electrical feedthroughs. Each electrical feedthrough comprises an opening in the base body for a conductor which is fed through the opening and embedded in a fixation material which seals the opening of the electrical feedthrough. The electrical feedthrough assembly further comprises at least one insulation element being affixed to the base body by means of an adhesive material, wherein the insulation element is preferably made from a natural or synthetic rubber or silicone rubber and the adhesive material preferably is an electrically insulating adhesive material. The at least one insulation element comprises at least one insulation section, wherein each electrical feedthrough has an assigned insulation section. Each insulation section has a conductor opening having an inner wall, wherein the respective conductor is fed through the conductor opening, wherein the insulation element is configured and arranged such that between the insulation section and the conductor and preferably the fixation material a cavity extending along the conductor is formed and such that between the inner wall of the conductor opening and a surface of the conductor at least one gap is formed. The gap allows access from the cavity to the environment. The cavity is at least partially filled with the adhesive material for affixing the insulation section. Furthermore, it is preferably provided that the cavity serves as a confinement for the adhesive material. Preferably, the at least one gap is realized in the form of at least one groove provided in the inner wall of the conductor opening. Preferably the conductor opening of the insulation section, through which the conductor is fed, has a cylindrical section and the inner wall of the cylindrical section of the conductor opening outside the at least one groove touches the respective conductor surface. This enables positioning of components during assembly and provides a seal.

The insulation element in combination with the adhesive material serves as electrical insulation for the conductors of the electrical feedthrough. This additional electrical insulation increases an electrical insulation distance or creeping distance between a conductor and the base body and/or between two conductors. In addition, because of the cavity provided inside the insulation element and extending along the conductor - which means that the cavity is extending over a certain distance of the conductor in the longitudinal direction of the conductor- and being at least partially filled with adhesive material, a longer bonded insulation distance is provided between conductor and insulation section which increases the insulation resistance. In other words, by means of the adhesive material present in the cavity the insulation section is adhered to the conductor. In addition, the insulation element may be affixed to the base body and/or the fixation material via a layer of adhesive material.

Thus preferably, the cavity is at least partially filled with adhesive material so that the insulation section is affixed to the fixation material and adhered to the conductor via the adhesive material. In an advantageous embodiment the fixation material may have a protrusion of the fixation material as described below.

Preferably, the cavity is at least partially filled with adhesive material so that the insulation section is affixed to the fixation material via the adhesive material and may be optionally adhered to the conductor via the adhesive material. In this variant the fixation material preferably comprises a protrusion of the fixation material (also called glass protrusion) which extends into the cavity of the insulation section. The protrusion is a portion of the fixation material extending beyond a side of the base body along the conductor, surrounds it and preferably is in contact with it. Preferably the protrusion is made of the same material as the fixation material and is thus an integral part of the fixation material. The protrusion may be designed as a glass meniscus, especially an arc shaped glass meniscus. The glass protrusion or meniscus may have a diameter that decreases continuously from a side of the base body along the conductor, thereby forming an arc. A variant wherein the insulation section is only affixed to the fixation material and its extending protrusion can be beneficial because in this case there is no connection between the base body and the conductor via the adhesive material.

Thus, the insulation element contributes to reduce the risk of short circuits, especially in case of wet or humid environments. In such environments, a water layer and/or dirt layer or the like might deposit on the surfaces of the feedthrough assembly, in particular on a surface of the fixation material insulating a conductor from the base body. Such a water film wetting the materials of the feedthrough assembly can in particular occur easily in an e-compressor with the feedthrough assembly configured as an e-compressor terminal. This is because the e-compressor has a very low temperature e.g. of lower than e.g. 5 °C or even negative temperatures, whereas the ambient temperature e.g. in the summer time might be higher than 20 °C. In such a case, a water film may form due to condensation.

By additionally insulating the conductor from the material of the base body and thus from a housing of a device comprising the feedthrough assembly, for example in e-compressor applications, short circuits due to conductive water and/or dirt films can be prevented. The adhesive material at least partially filling the cavity between the conductor and the insulation element prevents moisture that has penetrated between the conductor and the insulation section from penetrating further towards the base body.

The proposed cavity serves as a confinement for the adhesive material. The adhesive material is in particular confined to a space comprising the exposed surface of the fixation material and portions of the surfaces of the conductor and the insulation element. The confined space may also comprise portions of the surfaces of the base body. The adhesive material inside the cavity adheres the insulation section to a specific section of the conductor.

In an advantageous variant the cavity serves as a confinement for the adhesive material and the adhesive material is confined to a space comprising the exposed surface of the fixation material and portions of the surface the insulation element. The adhesive material inside the cavity adheres the insulation section to the fixation material and to its glass protrusion, if present.

In the scope of the invention, it is advantageous to use adhesive material between the insulation section and a section of the conductor to create a longer bonded insulation distance. The adhesive material at least partially filling the cavity between the conductor and the insulation element prevents moisture that has penetrated between the conductor and the insulation section from penetrating further towards the base body. This can keep the insulation resistance of the assembly even if moisture penetrates between the inner wall of the conductor opening and the conductor surface.

The at least one gap provided between the inner wall of the conductor opening and conductor surface allows access to the cavity from outside, i.e. the environment. The gap serves as an air channel for venting. During affixing the insulation section to the feedthrough assembly by means of adhesive applied, gas such as air trapped in the cavity and/or inside the adhesive material must be able to escape so that adhesive material can move and rise along the conductor in the cavity when the insulation section is fitted, which is made possible by that air channel. This can be called "conductor-venting". As a result, a bonded long insulation distance along the conductor is created. Further venting reduces the risk that voids such as air bubbles remain within the adhesive material. As the material of the insulation element as well as the adhesive material serve as an electrical insulation of the conductor, any void would weaken the insulating properties and must be avoided. Further, the fill level in the cavity can also be monitored via the gap.

Preferably the at least one gap between inner wall and conductor surface is in the range of from 0.05 mm to 1 mm, preferably from 0.1 mm to 0.5 mm and particular preferably from 0.1 mm to 0.3 mm.

Preferably, the cavity is completely filled with the adhesive material. Further, the adhesive material in the cavity is particularly preferably free from any gas bubbles especially air bubbles trapped inside the adhesive material. In order to compensate for manufacturing tolerances, the volume provided by one gap or more gaps may be used as a reservoir for receiving any excess adhesive material after the cavity has been completely filled. Accordingly, the number and size of the gaps is preferably configured to provide a sufficiently large reservoir volume.

When the cavity is completely filled with adhesive material, the height of the adhesive material extending along the conductor may correspond to the height of the cavity. In the gap or the gaps the height of the adhesive material may be even higher.

The conductor opening of the insulation section and the conductor may be configured and arranged such that at least one gap is provided between the inner wall of the conductor opening and the conductor surface. E.g., the dimensions and/or shapes of conductor opening and conductor may be chosen accordingly. Preferably the at least one gap is realized in form of at least one groove provided in the inner wall of the conductor opening allowing access from the cavity to the environment. In other words, at least one groove may be configured in the inner wall providing a well-defined air channel for venting. The cavity preferably ends at the height where the at least one groove begins. - A groove may be a recess in the inner wall.

Preferably, the conductor opening of the insulation section, through which the conductor is fed, may have a cylindrical section. When the insulation section is placed on the conductor, the inner wall touches the conductor surface where no gap or groove is present. The gap or groove provided in the inner wall of the conductor opening provides access from the cavity to the environment.

Preferably, the inner wall of the cylindrical section of the conductor opening outside the groove(s) touches the respective conductor surface. It is particularly preferred that the inner wall of the conductor opening creates - by the pretensioning provided by the material of the insulation section - a seal with the conductor surface with the exception of the groove leading into the cavity.

As described above in connection with at least one gap the at least one groove not only serves as an air channel but also enables monitoring the fill level of the cavity and/or may provide a reservoir for receiving any excess adhesive material after the cavity has been completely filled. Preferably, the groove can widen in sections to provide an even larger reservoir for excess adhesive. In other words, the groove may have different shapes in different sections, e.g. a widened section with a larger depth and/or larger width than in another section.

Preferably, the inner wall of each formed conductor opening has 1 to 10, preferably 2 to 8, especially preferably 4 to 6 grooves. In case an insulation section has exactly one cavity, the insulation section accordingly comprises 1 to 10, preferably 2 to 8, especially preferably 4 to 6 grooves. Preferably, the grooves are evenly distributed, particularly symmetrically arranged, around the conductor opening. This enables the cavity to be vented evenly. By means of the inner wall subdivided by several grooves the insulation section can be positioned during assembly. If several grooves are provided in the inner wall, the sections between them form corresponding ribs of the inner wall serving for positioning and sealing. Generally, in order to provide grooves, the grooves may be introduced into the inner wall or ribs may be arranged on the wall, with the space between two ribs forming a groove.

Thus preferably, several grooves are provided in the inner wall, wherein sections between the grooves form ribs of the inner wall for positioning and sealing.

Preferably, the depth of the at least one groove is in the range of from 0.05 mm to 1 mm, preferably from 0.1 mm to 0.5 mm and particular preferably from 0.1 mm to 0.3 mm. Via the depth the desired reservoir for adhesive material may be adjusted.

The width of the at least one groove is not particularly limited. It must be wide enough to provide sufficient ventilation. The width also depends on the desired reservoir for adhesive material.

Depending on e.g. the shape of cavity and/or the protrusion of the fixation material (if present) the thickness of the adhesive material between components can vary. Preferably, the thickness of adhesive material is not uniform or constant.

In general, the shape of the cavity is not limited as long as the insulation section can be reliably bonded to the conductor and/or the fixation material via the adhesive material and the cavity can be sufficiently vented via at least one gap, preferably at least one groove. Preferably, the cavity has an outer shape that tapers in direction towards a tip of the conductor. In particular, a diameter of the cavity may decrease in direction towards a tip of the conductor. Preferably the tapering cavity is leading into the at least one gap between the inner wall and the conductor surface, preferably leading into the at least one groove provided in the inner wall of the conductor opening. This cavity shape provides good guidance for the applied adhesive material when the insulation element is pushed onto the conductor for attachment to the assembly. The adhesive material is allowed to move to the top of the cavity whereby gas, e.g. air, trapped in the cavity and/or inside the adhesive material can escape through the gap, preferably groove, so that the adhesive material in the cavity is particularly preferably free from any gas bubbles, e.g. air bubbles trapped inside the adhesive material.

Preferably, the cavity is a conical or frustoconical cavity with decreasing diameter in direction towards a tip of the conductor. Preferably the conical or frustoconical cavity opens into the at least one gap between the inner wall and the conductor, preferably opens into the at least one groove provided in the inner wall. Such a cavity shape, which tapers towards one side, allows the applied adhesive material to move along the conductor towards the gap, preferably groove, when the insulation element is pushed onto the conductor for attachment to the assembly, whereby at the same time the trapped gas, e.g. air can escape through the gap, preferably groove, so that the adhesive material in the cavity is particularly preferably free from any gas bubbles, e.g. air bubbles trapped inside the adhesive material.

Preferably each insulation section has exactly one cavity, preferably a circumferential cavity that runs around the conductor. In other words, the cavity preferably completely surrounds the conductor. Thus, the adhesive material inside the cavity completely surrounds the conductor. This is advantageous for the insulation resistance. Preferably the circumferential cavity may be a tapering cavity or be a cavity having a conical or frustoconical shape. However, it may be conceivable, that a tapering cavity, preferably an overall conical or frustoconical cavity, is divided into several compartments or section by at least one dividing wall, e.g. to increase stability. In this case each tapered compartment or section may open into at least one gap or groove provided in the inner wall of the conductor opening.

In general, the dimensions of the cavity, e.g. the greatest height and/or greatest width or diameter of the cavity, are not particularly limited and e.g. depend on the dimensions of the insulation element, especially insulation section, the dimensions of the feedthrough and the overall design of the feedthrough assembly.

Preferably, the cavity may have a greatest height measured in direction of a longitudinal axis of the conductor which is in the range of from 0.5 mm to 5,0 mm, preferably from 1,0 mm to 4,0 mm and particular preferably from 1,0 mm to 3,0 mm. The greatest height is preferably reached in a contact area with the conductor.

Preferably the greatest height of the cavity is at least twice, preferably at least three times, preferably at least five times as great as the thickness of an adhesive layer between a contact portion of the insulation section and the base body and/or fixation material.

The greatest diameter of the cavity may preferably be 10% to 120% larger than a diameter of the conductor. An advantageous lower limit could be 15% or 20% or 30%. An advantageous upper limit could be 100% or 75% or 50%. The diameter of the cavity depends, among other things, on the overall design of the electrical feedthrough assembly. For example, if a contact portion of the insulation section is to contact the base body, the greatest diameter of the cavity may be larger than in cases where the contact portion contacts the adhesive layer present on the fixation material. The greatest diameter may be present at the contact portion.

Generally, in the scope of the disclosure the contact portion of the insulation section is the part of the insulation section that is in contact with the base body and/or the fixation material either directly or via a layer of adhesive material. Preferably the width of the contact portion may be in the range of from 1 mm to 3 mm.

Preferably the insulation element is configured and arranged such that a contact portion of each insulation section is in contact with the base body and/or the fixation material and/or with the adhesive material forming a contact area, preferably a circumferential contact area. One end of the cavity extends between the contact area and the conductor.

Preferably the insulation element is configured and arranged such that the contact portion of each insulation section may directly contact the base body. Thus, the formed cavity is sealed against the surface of the base body. Then the at least one gap or groove is the main air channel for venting the cavity and the adhesive material.

Preferably the insulation element is configured and arranged such that the contact portion of each insulation section is in contact with the adhesive material, which is preferably provided as a layer preferably covering the fixation material and/or parts of the base body around the feedthrough opening. In such an arrangement it may be advantageous, if the insulation element is configured and arranged that for each insulation section a further air channel is formed, wherein a top wall of the further air channel is formed by the insulation element. The further air channel may completely surround the contact portion of the respective insulation section.

Preferably, a pocket for the adhesive material is defined by the base body and the fixation material, wherein the opening is located within said pocket. Such an arrangement is advantageous as the pocket provides a space or reservoir to receive the adhesive material. The pocket can in particular receive any excess adhesive material which is not required to connect a contact portion of the insulation section to the base body and/or the fixation material. Any overflow of the adhesive material to other sections of the base body, which may e.g. serve as sealing surfaces, is thus avoided. The provided reservoir may compensate for tolerances in the dosing of the adhesive material.

Preferably the contact portion of the insulation section may comprise a projection which extends into the pocket such that a space between a side wall of the pocket and a side wall of the projection is formed, wherein the adhesive material at least partially fills said space.

The contact portion, especially its projection (if present), may serve as a displacement body that displaces the adhesive material, thereby helping to ensure that the adhesive material enters into the cavity.

The shape of the insulation element may preferably be chosen such that when the insulation element is attached to the base body, there is always a space between the surface configured as the contact portion of the insulation sections and the fixation material and/or the base body. This ensures that there is always a layer of the adhesive material having a defined minimum thickness present between the fixation material and/or the base body and the contact portion. The shape of the insulation element may include further projections intended to directly abut against the base body to set a defined relative position between the insulation element and the base body.

Preferably, the thickness of a layer of the adhesive material between the contact portion of the insulation section and the base body and/or the fixation material may be in the range of from 0.05 mm to 1 mm, preferably from 0.1 mm to 0.5 mm and particular preferably from 0.2 mm to 0.3 mm. Preferably the thickness given above refers to the thickness of the layer of the adhesive material in the pocket.

Preferably, a width of the contact portion may be in the range of from 1 mm to 3 mm. This width ensures that in combination with typical materials for insulation elements a sufficient dielectric strength is provided for the part of the insulation section surrounding the conductor.

Accordingly, it is preferred to choose the material of the insulation element and its geometry, in particular a material thickness surrounding the conductor, such that a predetermined dielectric strength is achieved. Likewise, it is preferred to choose the adhesive material and the layer width and/or height of the layer formed by the adhesive material, e.g. present in the pocket, such that a predetermined dielectric strength is achieved. For example, the width of the material of the insulation element and/or the adhesive material surrounding the conductor is preferably chosen to be in the range of from 0.1 mm to 2 mm, more preferably from 0.2 mm to 1 mm. These features especially refer to the adhesive material layer, e.g. the layer in the pocket defined by the base body and the fixation material. In the area of the cavity the contained adhesive material provides additional insulation and dielectric strength wherein the dimensions mentioned above can also apply to the thickness of the adhesive material around the conductor inside the cavity.

The contact portions of the insulation element(s) may preferably be configured and arranged such that not the entire surface of the adhesive material facing towards the insulation element is contacted. Accordingly, a portion of the surface of the adhesive material remains open and allows any gasses such as air to leave the adhesive material and to enter the (further) air channel.

As described above, the feedthrough assembly may preferably comprise the further air channel that forms a connection from a surface of the adhesive material to the surrounding environment - in addition to the inventive "conductor venting " by the air channel provided by the at least one gap, preferably groove, described above - and thus allows any gas, such as air, which may be trapped within the adhesive material to escape laterally. This can be called "side venting". This reduces the risk that voids such as air bubbles remain within the adhesive. As the material of the insulation element as well as the adhesive material serve as an electrical insulation of the conductor, any void could weaken the insulating properties and thus it is advantage to avoid any voids or bubbles. In other words, in addition to the inventive "conductor venting" in the region of the conductor by the air channel provided by the at least one gap, preferably groove (described above) there may be an additional "side venting" by the further air channel.

As described above, a pocket for the adhesive material may be defined by the base body and the fixation material, wherein the opening is located within said pocket, and preferably a contact portion of the insulation sections may comprise a projection which extends into the pocket such that a space between a side wall of the pocket and a side wall of the projection is formed. The contact portion and the adhesive material may be arranged such that the adhesive material is only in direct contact with the contact portion and is not in contact with side walls of the projection. Alternatively, the adhesive material is arranged such that the adhesive material at least partially fills said space. Preferably, the projection extends into the pocket for a distance in the range of from 0.05 mm to 0.5 mm. For example, preferably in the range of from 0.1 mm to 0.2 mm.

Preferably, the pocket and/or the projection (if present) may have slanted side walls. Slanted side walls of the pocket reduce the risk of voids within the adhesive material or trapping air bubbles within the adhesive material.

In embodiments where the pocket has slanted side walls it is preferred that the projection of the insulation section having the contact portion has a matching slanted side wall shape. While the shape of the contact portion is preferably the same shape as the pocket, the dimensions of the contact portions are preferably chosen to be smaller than the dimensions of the pocket so that there is always a space present between a side wall of the pocket and a side wall of the projection of the insulation section. This space ensures that no seal may be created between the side wall and the insulation section such that any trapped air within the adhesive material can escape.

Preferably, a width of the further air channel may be in the range of from 0.2 mm to 1 mm. For example, the width of the further air channel is 0.5 mm. Preferably, a height of the further air channel is in the range of from 0.2 mm to 1 mm. For example, the height of the further air channel is 0.5 mm. These dimensions provide a further air channel of sufficient size to allow any trapped gas such as air to escape from the adhesive material and provide a space to receive excess adhesive material.

Preferably, the insulation element comprises one insulation section for each electrical feedthrough and is formed as a single integral element. Alternatively, the electrical feedthrough assembly comprises one insulation element for each electrical feedthrough, wherein each insulation element has one insulation section. In the latter case, the number of insulation elements corresponds to the number of conductors.

Preferably, at least one of the insulation sections of the insulation element may have an outer cylindrical portion comprising the conductor opening and extending along a part of the conductor. Preferably, the outer cylindrical portion may have annular grooves and/or annular ribs at the outer surface, in particular on an outside facing wall, which may be used to provide a seal with a connector that may be attached to the conductor.

By means of the annular ridges or annular grooves, such a connector may be secured in place. Further, the annular ribs, annular ridges or annular grooves may provide a seal to prevent dirt or fluids from entering the space between the conductor and the cylindrical portion when a connector is attached. The annular ribs, annular rings, annular ridges and/or annular grooves can be arranged such that an annular ring or annular groove is formed. It is also possible to arrange set-in-rings over the outside facing wall of the cylindrical portions. Such a set-in-ring may, for example, be secured in an annular groove arranged in the outside facing wall of the extension portion.

Preferably, a top surface of the insulation sections may be provided with an annular slot which surrounds the conductor opening. This slot further enlarges the creepage distance between the base body and the conductor.

Preferably the assembly comprises at least one further insulation element arranged on a side of the base body opposite of the at least one insulation element. In other words, the feedthrough assembly may comprise additional insulation on a second opposite side of the base body. In such a case, this additional insulation may be configured in the same manner as the insulation element on the first side of the base body or may be configured differently (e.g. without cavity and gap or groove for venting). For example, it is also possible to provide a single insulation element as a single integral element on the first side and one insulation element per conductor on the second side.

The insulation element and/or the further insulation element is preferably made from a resilient material, in particular a natural or synthetic rubber, in particular a fluoroelastomer, an ethylene propylene diene monomer (EPDM) rubber, a hydrogenated nitrile-butadiene rubber (HNBR) or a silicone rubber.

Further suitable materials for the insulation element include thermoplastic or thermosetting plastic materials.

With respect to a housing of an electrical compressor, to which the electrical feedthrough assembly may be attached, the insulation element may be arranged on the side facing towards the outside of the housing. Additionally or alternatively, the insulation element may be arranged on the side facing towards the inside of the housing. In particular, the assembly may comprise two insulation elements, one arranged on the outside facing side and one on the inside facing side. In this case the second insulation element may be configured and arranged corresponding to the above-described insulation element or may be configured and arranged differently, e.g. at least on insulation section may be without cavity and/or gap, preferably groove provided in the inner wall of the conductor opening etc.

For example, when the proposed electrical feedthrough assembly is connected to a housing of an electric compressor, it is preferred to use a HNBR rubber or silicone rubber for an insulation element on the side of the assembly facing towards the inverter. For insulation elements facing towards the motor side, it is preferred to use a HNBR rubber.

In principle, the adhesive material may be selected from any known electric insulating adhesive material. Preferably, the adhesive material is an epoxy adhesive, an acrylate adhesive, a polyurethane adhesive, or a silicone adhesive.

Preferably, the material of the base body is a metal. More preferably, the base body comprises as a material steel, especially stainless steel, most preferred structural steel, preferably microalloyed steel, most preferred structural steel in form of microalloyed steel. Microalloyed steel is a type of alloy steel that contains small amounts of alloying elements (0.05 to 0.15 %), including niobium, vanadium, titanium, molybdenum, zirconium, boron and rare-earth metals. They are used to refine the grain microstructure or facilitate precipitation hardening. The yield strength of microalloyed steel is between 275 and 750 MPa without heat treatment. Weldability is good and can even be improved by reducing carbon content while maintaining strength. Fatigue life and wear resistance are superior to similar heat-treated steels. Cold-worked microalloyed steels do not require as much cold working to achieve the same strength as other carbon steel; this also leads to greater ductility. By using microalloyed steel as material, a high bending stiffness and strength could be provided.

In order to improve the resistance against high voltage flashovers, the edges of the through holes may be provided with a rounded edge or a chamfer. Such an arrangement reduces the occurrence of sharp edges and thus lowers the strength of an electrical field.

Preferably, the base body includes means for improving resistance against bending. These means are preferably selected from an elevated area, wherein the opening is located within the elevated area, and/or a pulled-up edge. However, base body variants without means for improving resistance against bending may be possible and advantageous, i.e. such a base body may be plate like and flat.

Such an elevated area may be a single area encompassing all openings of the base body. In an alternative embodiment, the base body could comprise several separated elevated areas, wherein each of the elevated areas encompasses a single one of the openings. The elevated area(s) may, for example be formed into a plate like precursor of the base body e.g. by means of a stamping process to form the base body.

The pulled-up edge and the base body may be configured as a single part or the pulled-up edge may be configured as a separate part, which could be joined with the base body by fusing. The advantage of the pulled-up edge to be a separate part is that production of both parts - base body and pulled up edge - could be organized separately.

However, in an alternative embodiment, the base body is reshaped in order to provide the pulled-up edge. Such a reshaping process could be e.g. stamping a plate like precursor element in order to form the base body.

Preferably, in embodiments wherein the base body comprises an elevated portion which surrounds and/or comprises the through openings of the electrical feedthroughs and in which the insulation element is placed onto the conductors at the side of the base body having said elevation, it may be preferred that the insulation element comprises a skirt. This skirt is configured to surround at least a part of the side wall of the elevation such that an additional further air channel is formed between said side wall and the surrounding skirt. This additional further air channel allows any trapped air in the adhesive material to escape while the skirt provides a barrier between a defined position of the adhesive material and a sealing area of the base body. Any excess adhesive may then be trapped by the skirt so that the sealing area remains clean and free from the adhesive material.

In case the base comprises several separated elevated areas, wherein each of the elevated areas encompasses a single one of the openings, it may be preferred that the insulation sections of the insulation element(s) comprise skirts. In case the insulation element comprises several insulation sections and is formed as a single integral element, the skirts of adjacent insulation sections may be formed integrally, i.e. in some sections they may be formed in one piece.

Preferably, the material of the conductor is a metal. More preferably, the conductor may comprise as a material stainless steel or a Ni-Fe- material or a Fe-Cr material or a central core made of copper surrounded by stainless steel or a Ni-Fe-material.

The fixation material is preferably selected from a glass, a ceramic or a glass ceramic material. Preferably, the fixation material is a glass material so that a glass-to-metal seal (GTMS) is provided between the base body, the conductor and the fixation material.

Preferably, the base body, the least one conductor and the fixation material form a compression seal. Accordingly, a first coefficient of thermal expansion of the base body is preferably chosen to be larger than a second coefficient of thermal expansion of the fixation material. Preferably, for obtaining a compression seal, a difference between the first coefficient of thermal expansion is at least 2 ppm/K and more preferably the difference between the first coefficient of thermal expansion is at least 5 ppm/K. A third coefficient of thermal expansion of the conductor material is preferably chosen to be about equal to or less than the second coefficient of thermal expansion of the fixation material. Two coefficients of thermal expansion are considered to be about equal if the difference is less than 2 ppm/K.

Alternatively to a compression seal, the material of the base body, the fixation material and the conductor material may be chosen such that their respective coefficients of thermal expansion are about equal, wherein a difference of less than 2 ppm/K is considered to be about equal.

Preferably, the formed seal between the opening of the base body, the fixation material and the conductor is a hermetical seal. In particular a feedthrough having a He leakage rate of better than 1•10⁻⁷ mbar I/s, especially 1•10⁻⁸ mbar I/s for a pressure difference of 1 bar is considered to be hermetic.

Preferably, the base body may comprise an adhesion area, preferably located within a pocket, with a roughness for bonding with the adhesive material.

The rough area may, for example, be provided by a stamping or an embossing process for enhancing adhesion of the adhesive material. The roughness can also be provided by a rolled textured sheet material or by a rolled texture with a stamping step by a tool. Due to the good adhesion a connection between the material of the base body and the adhesive material is improved. Additionally or alternatively, structures such as tenons and/or pins and/or spigots can be provided within the adhesion area. Further, structures such as a ring embossing and/or ring shaped grooves can be formed to improve the adhesion. Such tenons can be formed from the sheet, eventually in form of a mushroom shaped head part. A ring embossing around the fixation material in which the conductor is fed through the base body would be possible. In any case by the structure of the surface of the base body within the adhesion area, the connection of adhesive to the base body can be improved. In addition or alternatively to structuring a part of the surface of the base body it is also conceivable to provide such structures on parts of the surface of the insulation element.

Preferably, a part of the surface of the base body may be configured as a sealing area. In the sealing area, it is preferred that the surface of the base body is smooth and flat. In particular, it is preferred that within the sealing area the surface of the base body has a flatness of at least 0.1 mm, preferably at least 0.07 mm, most preferably from 0.01 mm to 0.07 mm. Such a smooth and/or flat area facilitates creating a good and tight seal. A surface roughness is preferably R_{z} 10 µm or better.

Preferably, the base body of the feedthrough assembly comprises mounting means to facilitate attaching of the feedthrough assembly to a housing or housing part of a device, such as an electric compressor. Preferably, the mounting means are configured as attachment bores or screw bores, wherein the base body preferably comprises at least two of said bores. The base body may additionally or alternatively comprise centering means such as protrusions or indentations to facilitate exact placement of the base body and thus of the feedthrough assembly with respect to a housing or part of a housing of a device.

The base body may be configured to have an elongated shape in which all the openings for the conductors are arranged along a line. However, other configurations, for example a round base body where the openings are evenly distributed along a circle or an arc shaped base body wherein the openings are arranged along a straight or bent line, are also possible.

In a variant it may be preferred that the fixation material is arranged such that the fixation material does not extend beyond the at least one opening in the base body, at least on the side facing towards the insulation element. In particular, in that variant a glass meniscus surrounding the conductor and extending beyond the base body should be avoided. In such an arrangement, the fixation material can be arranged flush with the surface of the opening or may be recessed relatively to the surface of the opening.

Arranging the fixation material such that it does not extend beyond the base body allows bending of the conductors without the risk of damaging the fixation material. For example, when a glass material is used as fixation material, a formed glass meniscus surrounding the conductor and extending beyond the opening could be subject to strong forces when the conductor is bent which could lead to cracks or damages to the glass. Thus, the proposed arrangement of the fixation material allows bending of the conductors as required. Further, the shape of such a glass meniscus may be subject to strong variation making it difficult to determine the correct amount of adhesive material.

Alternatively, in a variant the fixation material may be arranged such that the fixation material fills the opening and extends onto the base body in an area surrounding the opening, wherein the fixation material may be preferably free from a glass meniscus surrounding the conductor. In such a configuration, the fixation material covering a part of the base bodies surface serves as an additional electrical insulation.

In a variant it may be preferred that the fixation material has a glass protrusion, preferably a glass meniscus, surrounding the conductor and extending into the cavity of the insulation section. The cavity can compensate for variations in the shape and/or volume of the glass protrusion, preferably glass meniscus, and volume of the adhesive material. Glass protrusions or glass menisci on both sides of the base body may also be possible.

Preferably, the electrical feedthrough assembly is configured as an e-compressor terminal, wherein the base body is configured for attachment to a housing of an e-compressor.

A method for manufacturing of an electrical feedthrough assembly as described herein is also disclosed. The method comprising the steps of
- providing of a base body assembly, the base body assembly comprising a base body with at least one feedthrough having at least one conductor embedded in fixation material that is fed through an opening of the base body providing a glass-to-metal seal (GTMS),
- providing of an insulation element comprising at least one insulation section, wherein each electrical feedthrough has an assigned insulation section; each insulation section has a conductor opening having an inner wall and a cavity;
- applying of adhesive material to an adhesive area of the base body assembly and
- placing of the insulation element onto the base body assembly such that the conductor is fed through conductor opening of respective insulation section of the insulation element and the cavity is formed between insulation section, conductor and base body, wherein the insulation element is pushed into the previously applied adhesive material which is allowed to move in the cavity along the conductor and to fill the cavity at least partially, whereby at the same time the trapped gas, e.g. air can escape through at least one gap formed between the inner wall of the conductor opening and the conductor.

Preferably to realize the at least one gap, the inner wall of the conductor opening is structured in such a way that a groove is formed.

**In** the inventive method the gap connecting the cavity to the environment serves as an air channel for venting. During placing the insulation section to the base body assembly comprising base body, fixation material and conductor gas such as air trapped in the cavity and/or inside the adhesive material can escape so that adhesive material can move and rise along the conductor in the cavity. As a result, via the adhesive material present in the cavity the insulation section is bonded to the conductor surface for a certain distance. Further, venting reduces the risk that voids such as air bubbles remain within the adhesive material and/or the cavity. Preferably, no air bubbles remain trapped within the cavity so that the adhesive within the cavity is free from voids or bubbles. As the material of the insulation element as well as the adhesive material serve as an electrical insulation of the conductor, any void would weaken the insulating properties. By means of the inventive method the insulation element can be securely attached preferably without any gas bubbles or voids in the adhesive material and without excess adhesive material overflowing onto other parts of the feedthrough during assembling.

As the adhesive material can move and rise in the cavity along the conductor, a longer bonded insulation distance is created between the conductor and the insulation section. Further, the fill level in the cavity can also be monitored via the gap during the placing step.

Preferably, the insulation element may be configured such that further air channels are formed around each of contact portions of the insulation sections.

Optionally, a further insulation element may be arranged on the opposite side of the base body by turning the base body and repeating the respective assembly steps.

The electrical feedthrough assembly described herein is particularly suited for use as a connection terminal for an electric compressor. The feedthrough assembly may be configured as part of a housing of the electric compressor or may be attached to a housing or a part of a housing for an electric compressor.

Accordingly, it is a further aspect of the invention to provide an electric compressor comprising one of the electrical feedthrough assemblies described herein.

It is to be understood that the features mentioned above and those to be explained below can be used not only in the combination indicated in each case, but also in other combinations or alone, without leaving the scope of the present invention.

Preferred embodiments of the invention are shown in the figures and will be explained in more detail in the following description, wherein identical reference signs refer to identical or similar components or elements.

### Brief description of the figures:

Figure 1a shows a section of a cross-section of a first example embodiment of a feedthrough assembly comprising a base body and an insulation element,
Figure 1b shows a section of another cross-section of the first example embodiment of a feedthrough assembly,
Figure 2a shows a second example embodiment of a feedthrough assembly comprising a base body and an insulation element in a perspective view,
Figure 2b shows the embodiment of the feedthrough assembly of figure 2a in a cross-sectional side view,
Figure 3a shows a third embodiment of a feedthrough assembly comprising a base body and an insulation element in a perspective view,
Figure 3b shows the third embodiment of the feedthrough assembly of figure 3a in a cross-sectional side view,
Figure 4 shows a fourth embodiment of the feedthrough assembly in a cross-sectional side view,
Figure 5 shows the insulation element of a further embodiment of the feedthrough assembly in a top view,
Figure 6 shows another further embodiment of the feedthrough assembly in a cross-section, and
Figure 7 shows a variant of the embodiment of figure 6.

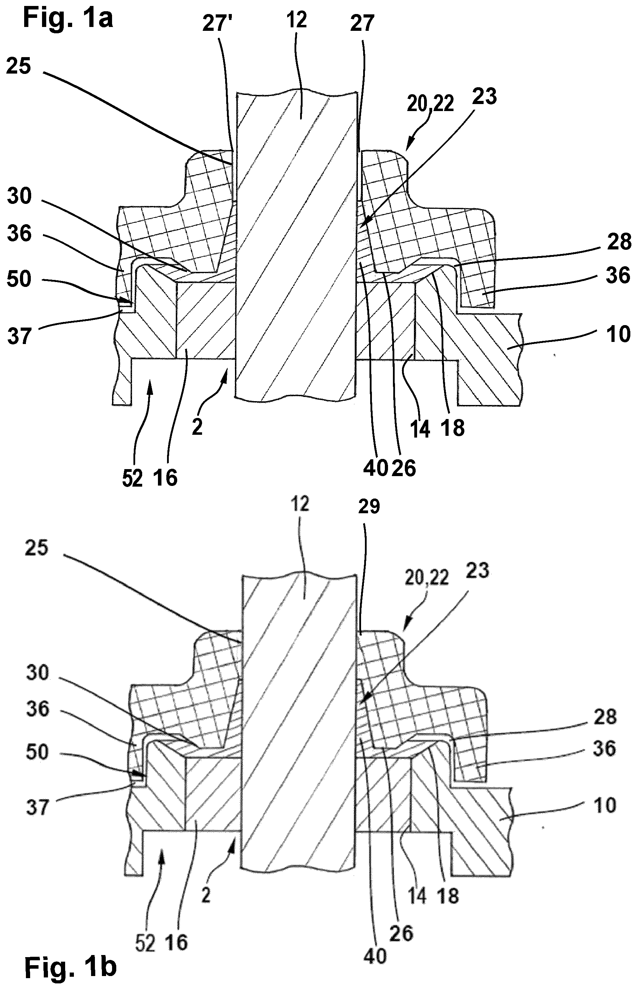

Figure 1a shows a cross-section of a first exemplary embodiment of a feedthrough assembly 1. The feedthrough assembly 1 may comprise several feedthroughs from which in the depicted example one electrical feedthrough 2 is shown. Each of the electrical feedthroughs 2 has an opening 14 within a base body 10 and a conductor 12 which is fed through the respective opening 14. A fixation material 16 fixes the conductor 12 and seals the opening 14.

The feedthrough assembly 1 additionally comprises an insulation element 20 affixed to the base body 10 for enhancing the electrical insulation which is further described below.

As can be seen in the cross-section view of figure 1a, the conductor 12 is fed through an opening 14 in the base body 10 and is held by a fixation material 16. The fixation material 16 is, for example, selected from a glass and is electrically insulating. Further, the fixation material 16 in this example is arranged such that the respective opening 14 is sealed. In the example it does not protrude beyond the opening 14. In particular, the fixation material 16 here does not form a glass meniscus surrounding the conductor 12 and extending beyond the base body 10.

In order to further improve an electrical insulation between the base body 10 and the conductors 12, an insulation element 20 is provided. In the exemplary embodiment of figure 1a, the insulation element 20 is attached to an upper side of the base body 10. However, the insulation element 20 could also be arranged on a bottom side of the base body 10 and it is also possible to provide two insulation elements 20, one attached to the bottom side, and one attached to the top side of the base body 10.

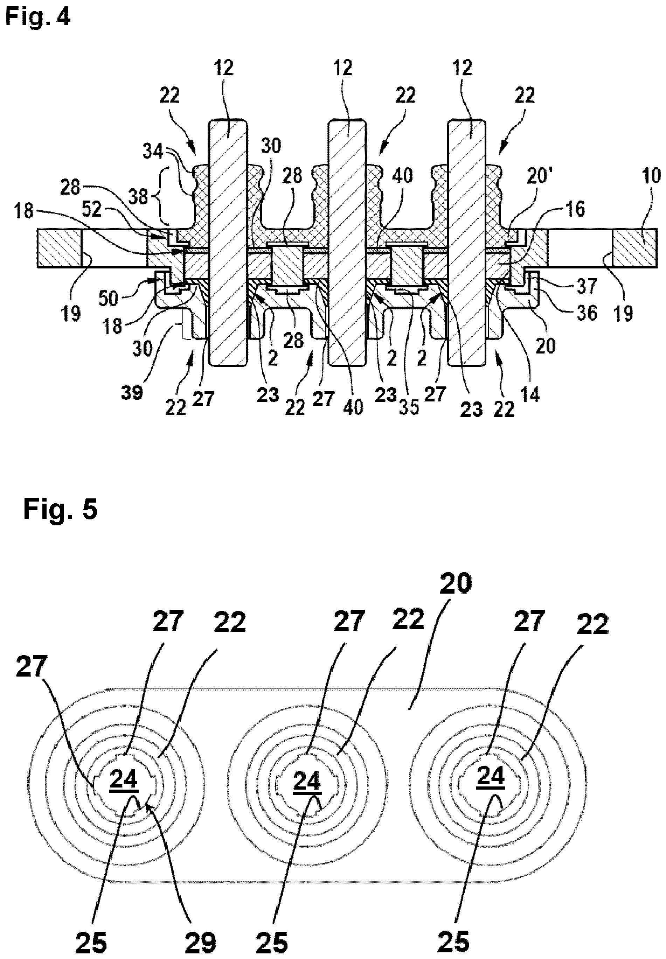

The insulation element 20 comprises in the shown exemplary embodiment an insulation section 22 for the feedthrough 2 and its conductor 12. The insulation section 22 has a conductor opening 24 (not depicted here, see figure 5) having an inner wall 25 wherein the conductor 12 is fed through the conductor opening.

For attachment of the insulation element 20 to the base body 10 and/or the fixation material 16, an adhesive material 40 is used here forming a layer between a contact portion 26 of the insulation section 22 and the base body 10 and/or the fixation material 16. In another advantageous embodiment, not shown, the insulation section 22 may be configured in such a way that its contact portion 26 directly contacts the base body 10.

As can be seen, the insulation element 20 being configured and arranged such that between the insulation section 22 and the conductor 12 a cavity 23 extending along the conductor 12 is formed and such that between the inner wall 25 of the conductor opening 24 and the surface of the conductor 12 at least one gap 27' is formed allowing access from the cavity 23 to the surrounding environment. The cavity 23 is at least partially filled with adhesive material 40. By means of the adhesive material 40 present in the cavity 23 the insulation section 22 is additionally adhered to the conductor 12. Thus, the adhesive material 40 between the insulation section 22 and a section of the conductor 12 creates a longer bonded insulation distance compared to the prior art without cavity. This arrangement and design ensure insulation resistance of the assembly even if moisture penetrates between the inner wall 25 of the conductor opening 24 and the conductor surface.

The at least one gap 27' provided between the inner wall 25 of the conductor opening and conductor 12 allows access from the cavity 23 towards outside. The gap 27' serves as an air channel for venting. During affixing the insulation element 20 to the feedthrough assembly 1 by pushing the insulation section 22 onto the conductor 12, gas such as air trapped in the cavity 23 and in the adhesive material 40 can escape along the conductor 12 to the environment ("conductor venting") so that the previously applied adhesive material 40 can move and rise inside the cavity 23 along the conductor 12 and create the bonded insulation distance. Further, this reduces the risk that voids such as air bubbles remain within the adhesive material 40 so that the adhesive material 40 in the cavity 23 is particularly preferably free from any gas bubbles, e.g. air bubbles trapped inside the adhesive material. In addition, the fill level in the cavity 23 can be monitored via the gap 27', and by the number and size of gaps a reservoir for excess adhesive material may be provided.

In the example the cavity 23 is completely filled with adhesive material 40, i.e. the height of the adhesive material in the cavity corresponds to the height of the cavity. In the gap 27' or the gaps the height of the adhesive material may be even higher.

As shown in figure 1a, the cavity 23 is preferably a circumferential cavity running around the conductor 12. It has an outer shape that tapers in direction towards a tip of the conductor 12 leading into the at least one gap 27' between the inner wall 25 and the conductor 12. This tapering shape provides good guidance for the applied adhesive material 40 when the insulation element 20 is pushed onto the conductor 12 for attachment to the assembly. The adhesive material 40 can move along the conductor 12 towards the gap whereby at the same time the trapped gas, e.g. air can escape through the gap.

Here, the cavity 23 exemplarily is a conical or frustoconical cavity with decreasing diameter in direction towards a tip of the conductor 12. Of course, other cavity shapes are possible, e.g. cylindrical shapes or asymmetrical shapes or any other suitable shapes. Here, the conical or frustoconical cavity 23 opens into the at least one gap 27' between the inner wall 25 and the conductor 12.

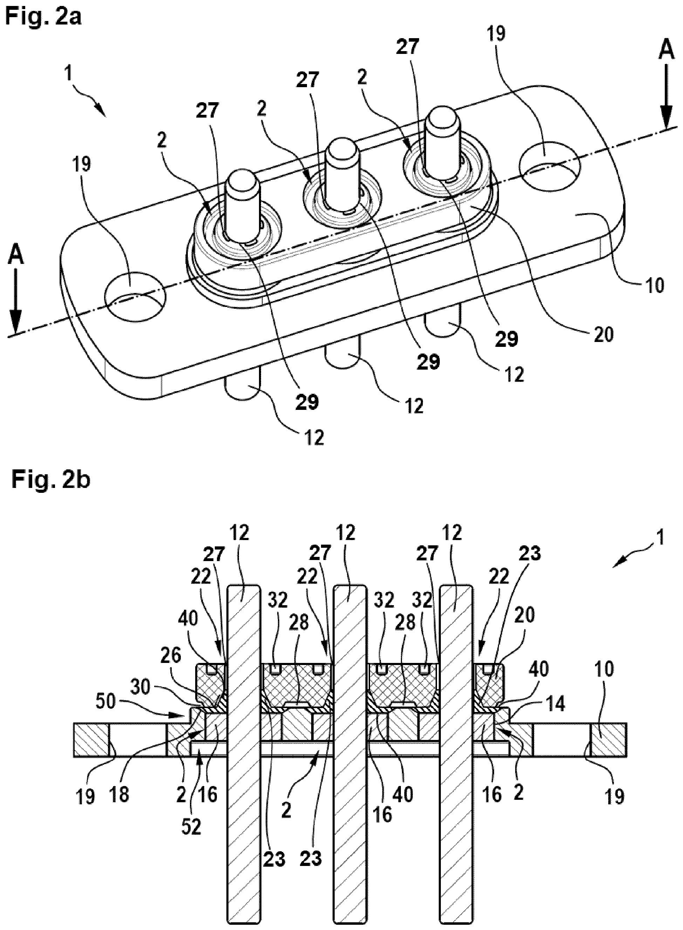

Further optional and advantageous features are described as follows which can also be advantageous for other embodiments of the feedthrough assembly:
In general, and without being limited to any particular embodiment, the at least one gap 27' may be realized in form of at least one groove 27 provided in the inner wall 25 of the conductor opening 24, as can be seen in figures 2a, 3a and 5 and will be described there. In other words, at least one groove may be configured in the inner wall 25 allowing access to the cavity 23 and providing a well-defined air channel for venting. Inside the insulation section 22 the cavity ends at the height where the at least one groove begins.

The base body 10 and the fixation material 16 may form a pocket 18, wherein every insulation section 22 has a contact portion 26 facing towards the respective pocket 18. Here, the contact portion 26 has a projection 30. Of course, variants without such projection are possible. The adhesive material 40 is received in the pocket 18 and is in direct contact with a contact surface 26 of the contact portion 26 (here projection 30) of the insulation section 22. As the fixation material 16 in this example is essentially flat and does not form a glass meniscus, an essentially flat surface of the fixation material 16 is provided which transitions to the side wall of the pocket 18 provided by the base body 10 without any steps or gaps.

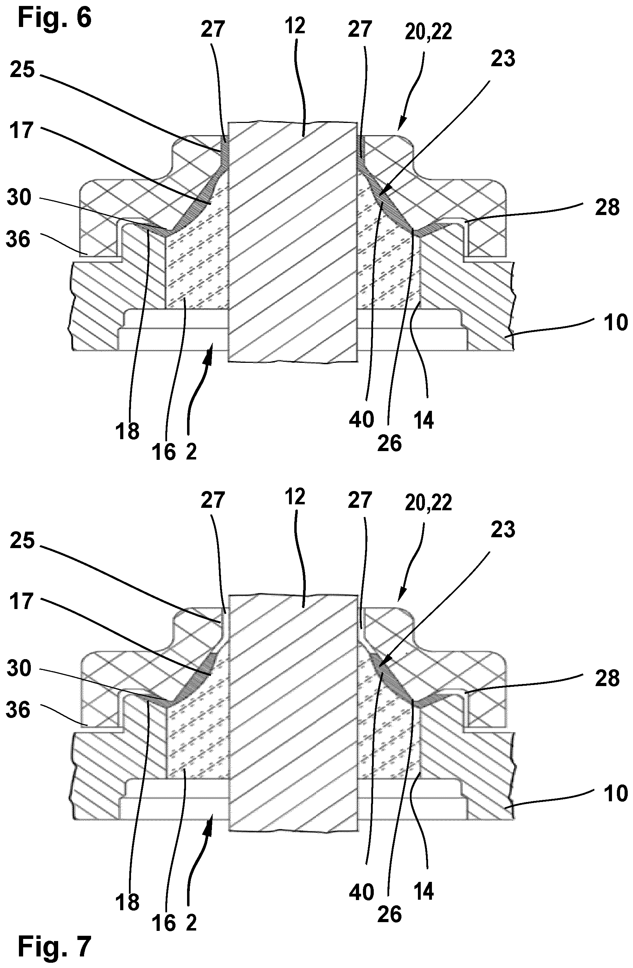

In a variant (e.g. shown in figures 6, 7) the fixation material 16 may have a glass protrusion 17, e.g. in form of a glass meniscus, surrounding the conductor 12 and extending into the cavity 23 of the insulation section 22. The cavity can compensate for variations in the shape and/or volume of the glass protrusion and volume of the adhesive material 40. A glass protrusion formed at the other side of the base body or glass protrusions on both sides of the base body may also be possible. A glass protrusion may be realized in combination with a pocket 18 or without a pocket. The same applies accordingly if the glass protrusion is designed as a glass meniscus, preferably an arc shaped glass meniscus.

The contact surface 26 of the insulation section 22 is here configured and arranged so that it does not cover the entire surface of the adhesive material 40 facing towards the insulation element 20. A portion of the surface of the adhesive material 40 remains uncovered. Thus, a further air channel 28 is formed surrounding the contact portion 26 and projection 30 and thus the conductor 12. A side wall of the further air channel 28 is defined by side wall of the projection 30, and recessed areas of the insulation element 20 define a top wall of the further air channel 28. The further air channel 28 is also open to the surrounding environment of the electrical feedthrough assembly 1 so that any gas or air can escape to the sides ("side venting"). This additionally supports the adhesive material 40 to form an essentially gapless and bubble free structure, e.g. layer. In this embodiment, the insulation section 22 has a skirt 36 which surrounds an elevated area 50 of the base body 10 and also creates a further air channel 37. The skirt 36 serves as a further measure to contain excess adhesive material 40 while still allowing gas or trapped air to escape to the surrounding environment. Further details of the further air channels 28 will be described in connection with figures 2a, 2b, 3a, 3b and 4.

For improving the resistance of the base body 10 against deflection or bending, the base body 10 comprises an elevated area 50 on one side (here the upper side) and a corresponding recessed area 52 on the other side (here the bottom side) of the base body 10. In this depicted example the base body 10 comprises one elevated area 50 for each of the electrical feedthroughs 2. Alternatively and shown in figures 2a, 2b, 3a, 3b and 4, the elevated area 50 could be configured as a single elevated area 50 and all electrical feedthroughs 2 are arranged on said elevated area 50.

Of course, flat base bodies 10 without elevated and/or recessed areas are possible. I.e., in a further embodiment (not shown) an insulation element 20 with cavity 23 inside an insulation section 22 may be affixed to a plate like, flat base body.

Figure 1b shows the first exemplary embodiment as explained in connection with figure 1a but with the cross-section positioned at a different location, so that the gaps 27' or grooves 27 provided in the inner wall 25 of the conductor opening 24 are not cut. The conductor opening 24 of the insulation section 22, through which the conductor 12 is fed, has a cylindrical section. As can be seen, the inner wall 25 of the cylindrical section of the conductor opening 24 outside the gaps 27' or grooves 27 depicted in figure 1a touches the conductor surface. In other words, in the area of the conductor opening of the insulation section outside the at least one gap or groove, the inner wall 25 touches the conductor surface, which ensures that the components are positioned during assembly and centered relative to each other and that the insulation section 22 seals against the conductor 12.

Generally, when gaps 27' or grooves 27 are provided in the inner wall 25 of the conductor opening 24, the sections between them form corresponding ribs 29 of the inner wall serving for positioning, centering and sealing. Generally, in order to provide grooves, the grooves may be introduced into the inner wall of the conductor opening (e.g. in the form of cut-outs or recesses) or ribs may be arranged on the wall, with the space between two ribs forming a groove.

Figure 2a shows a second exemplary embodiment of a feedthrough assembly 1 in a perspective view.

The feedthrough assembly 1 comprises in the depicted example three electrical feedthroughs 2. Each of the electrical feedthroughs 2 has an opening 14 (see figure 2b) within a base body 10 and a conductor 12 which is fed through the respective opening 14. A fixation material 16 fixes the conductor 12 and seals the opening 14. The base body 10 comprises in the depicted example two bore holes 19 for attaching of the feedthrough assembly 1 to a housing (not shown). The feedthrough assembly 1 additionally comprises an insulation element 20 for enhancing the electrical insulation which is further described with respect to figure 2b.

Figure 2b shows the feedthrough assembly 1 of figure 2a in a cross-sectional view along the line marked with A-A in figure 2a.

As can be seen in figure 2b, each of the three conductors 12 is fed through an opening 14 in the base body 10 and is held by a fixation material 16. The fixation material 16 is, for example, selected from a glass and is electrically insulating. Further, in this example the fixation material 16 is arranged such that it does not protrude beyond the opening 14. In the embodiment of figures 2a and 2b, the base body 10 has an elongated shape in which the three openings 14 are arranged along a line. Other configurations, for example where the openings 14 are evenly distributed along a circle, are also possible. In this example the base body 10 comprises an elevated area 50 on the upper side and a corresponding recessed area 52 on the bottom side of the base body 10 for improving the resistance of the base body 10 against deflection or bending. The elevated area 50 is configured as a single elevated area 50 and all electrical feedthroughs 2 are arranged on said elevated area 50.

In order to further improve an electrical insulation between the base body 10 and the conductors 12, an insulation element 20 is provided. In the exemplary embodiment of figures 2a and 2b, the insulation element 20 is attached to a upper side of the base body 10. However, the insulation element 20 could also be arranged on a bottom side of the base body 10 and it is also possible to provide two insulation elements 20, one attached to the bottom side, and one attached to the top side of the base body 10, as shown e.g. in figure 4.

The insulation element 20 comprises in the shown exemplary embodiment three insulation sections 22, one for each of the feedthroughs 2 and their respective conductors 12. Each of the insulation sections 22 has a conductor opening having an inner wall 25 wherein the respective conductor 12 is fed through the respective conductor opening 24. Further, in this example, the insulation sections 22 of the second embodiment have a common top wall comprising slots 32 to further increase a creepage distance between two neighboring conductors 12.

For attachment of the insulation element 20 to the base body 10 and/or the fixation material 16, an adhesive material 40 is used here forming a layer between contact portions 26 of the insulation sections 22 and the base body 10 and/or the fixation material 16.

As can be seen, the insulation element 20 being configured and arranged such that in each case between the insulation section 22 and the conductor 12 a cavity 23 extending along the conductor 12 is formed and such that in each case between the inner wall 25 of the conductor opening 24 and the surface of the conductor 12 at least one gap 27' is formed allowing access from the cavity 23 to the surrounding environment. The cavities 23 are filled with adhesive material 40. By means of the adhesive material 40 present in the cavities 23 the insulation sections 22 of the insulation element 20 are additionally adhered to the conductors 12 for a specified distance. The adhesive material 40 between the insulation section 22 and a section of the conductor 12 creates a longer bonded insulation distance for each feedthrough 2.

As can be seen in figures 2a and 2b the at least one gap 27' is realized in form of at least one groove 27 provided in the inner wall 25 of the conductor opening 24 (also see figure 5). In the example depicted, four grooves 27 are provided in the inner wall 25 and distributed around the conductor opening 24 forming air channels for venting. Of course, the number, size, dimensions and arrangement of the grooves may be different in other advantageous embodiments.

Looking at one feedthrough 2, the conductor opening 24 of the insulation section 22, through which the conductor 12 is fed, has an inner cylindrical section 39 (not depicted here, see figure 4). When the insulation section 22 is placed on the conductor 12, at the inner cylindrical section 39 the inner wall 25 touches the conductor 12 where no groove is present. As several grooves 27 are provided in the inner wall 25, sections of the inner wall 25 remain between the grooves 27 and form ribs 29 touching the surface of the conductor 12 and thus serving for positioning and sealing (see figure 2a). It is particularly preferred that the inner wall 25 of the conductor opening 24 creates - by the pretensioning provided by the material of the insulation section - a seal with the conductor with the exception of the grooves 27 leading into the cavity 23.

When the insulation sections 22 of the insulation element 20 are pushed onto the conductors 12 during affixing the insulation element 20 to the feedthrough assembly 1 by means of adhesive material 40 applied, gas such as air trapped inside the cavities 23 and inside the adhesive material 40 can escape along the conductors 12 to the environment via the grooves 27 ("conductor venting") so that the previously applied adhesive material 40 can move and rise along the conductors 12 in the cavities 23. As a result, the insulation sections are adhered to sections of the conductors.

Here, the cavities 23 are exemplarily configured and shaped similarly to the cavity described above in connection with the first embodiment. Of course, this does not have to be the case. The general designs and functions of cavities and gaps (here grooves) and advantageous further developments and variants have already been described in the introduction and in connection with the first embodiment.

The insulation sections 22 of the insulation element 20 are also attached to the base body 10 and/or the fixation material 16 via the adhesive material 40. Here, the base body 10 and the fixation material 16 form pockets 18, wherein every insulation section 22 has a contact portion 26 - here with a projection 30 - facing towards the respective pocket 18. The adhesive material 40 is received in the pockets 18 and is in direct contact with contact surfaces 26 of the respective contact portions or projections 30 of the insulation sections 22.

Similar to the first embodiment, the second embodiment also contains further air channels 28 surrounding the contact portions 26 or projections 30 and thus the conductors 12 for "side venting" of the adhesive material 40 as described in connection with figure 1a. Here, the insulation element 20 or insulation sections 22 have no skirt surrounding an elevated area 50 of the base body 10. A portion of the surface of the adhesive material 40 remains uncovered and allows gasses to escape from the adhesive material 40 and to enter the further air channels 28.

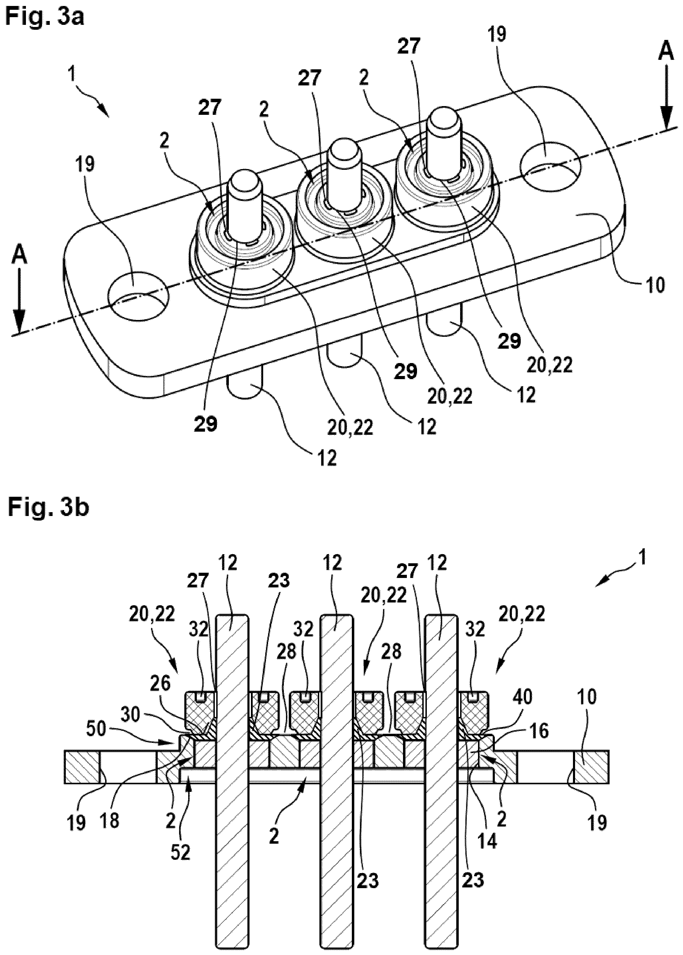

Figure 3a shows a third exemplary embodiment of a feedthrough assembly 1 in a perspective view. The feedthrough assembly 1 comprises in the depicted example three electrical feedthroughs 2. Each of the electrical feedthroughs 2 has an opening 14 (see figure 3b) within a base body 10 and a conductor 12 which is fed through the respective opening 14. A fixation material 16 (see figure 3b) fixes the conductor 12 and seals the opening 14.The base body 10 comprises in the depicted example two bore holes 19 for attaching of the feedthrough assembly 1 to a housing (not shown). The feedthrough assembly 1 additionally comprises three insulation elements 20 for enhancing the electrical insulation - one insulation element 20 for each of the electrical feedthroughs 2. The insulation elements 20 are further described with respect to figure 3b.

Figure 3b shows the feedthrough assembly 1 of figure 3a in a cross-sectional view along the line marked with A-A in figure 3a. The feedthrough assembly 1 of the third exemplary embodiment is similar to the second exemplary embodiment described with respect to figure 2a and 2b except for the configuration of the insulation elements 20. Instead of a single insulation element 20 having three insulation sections 22, the third exemplary embodiment of figures 3a and 3b comprises three insulation elements 20, wherein each of the insulation elements 20 has a single insulation section 22.

Each insulation element 20 comprises a cavity 23 and at least one gap - here exemplarily four groove 27 - in its insulation sections 22 for adhering the insulation sections 22 to the respective conductors 12 and thus providing a longer insulation distance along the conductors 12 by adhesive material 40 inside the cavities 23, as described above.

As can be seen in figure 3b, the provided further air channels 28 are open, i.e. they do not have a top wall, unlike in the second embodiment.

Figure 4 shows a fourth exemplary embodiment of the feedthrough assembly 1 in a cross-sectional side view. Similar to the embodiment described with respect to figures 2a and 2b, the electrical feedthrough assembly 1 comprises three electrical feedthroughs 2, each having an opening 14 in a base body 10 through which a conductor 12 is fed. A fixation material 16 seals the respective opening 14 and holds the conductor 12.

In this fourth exemplary embodiment, the electrical feedthrough assembly 1 comprises two insulation elements 20, 20'. One insulation element 20 is arranged on a bottom side of the base body 10 and a further insulation element 20' is arranged on a top side of the base body 10.

For improving the mechanical stability of the base body 10, here the base body 10 is provided with a recessed area 52 and a corresponding elevated area 50. The three electrical feedthroughs 2 are arranged within said recessed area 52 and the corresponding elevated area 50. Alternatively, the base body 10 could comprise one elevated area 50 for each of the electrical feedthroughs 2 as described in connection with figure 1a or the base body may be flat.

The insulation element 20 arranged on the bottom side is in this example configured as a single insulation element having three insulation sections 22. Each insulation section 22 has a contact portion 26 - here comprising a projection 30 - which is in direct contact with the adhesive material 40.

The insulation element 20 is configured and arranged such that in each case between the insulation section 22 and the conductor 12 a cavity 23 extending along the conductor 12 is formed and such that in each case between the inner wall 25 of the conductor opening 24 and the surface of the conductor 12 at least one gap, here at least one groove 27, is formed allowing access from the cavity 23 to the surrounding environment. The cavities 23 are filled with adhesive material 40. By means of the adhesive material 40 present in the cavities 23 the insulation sections 22 of the insulation element 20 are additionally adhered to the conductors 12. The adhesive material 40 between the insulation section 22 and a section of the conductor 12 creates a longer bonded insulation distance for each feedthrough 2. As can be seen grooves 27 are provided in the inner wall 25 of the conductor opening 24 forming air channels for venting. Outside the grooves 27 the inner wall 25 is touching the surface of the conductor 12 thus forming a seal between the conductor 12 and the insulation section 22 for each feedthrough 2.

Side walls of the contact portions 26, here provided with projections 30, define side walls of further air channels 28 and recessed parts of the insulation element 20 define top walls of the further air channels 28. For increasing the height of the further air channels 28, the insulation sections 22 of the insulation element 20' comprises a step 35.

In the example depicted in figure 4, the fixation material 16 is not flush with a surface of the openings 14 but is recessed and thus forms pockets 18 for receiving the adhesive material 40. Any excess adhesive material 40 can be contained inside said pockets 18. In case of the insulation element 20, a skirt 36 is provided which surrounds the elevated area 50 and creates a further air channel 37. The skirt 36 serves as a further measure to contain excess adhesive material 40 while still allowing any gas or trapped air to escape to the surrounding environment.

The further insulation element 20' arranged on the upper side is also configured as a single insulation element 20 having three insulation sections 22. Each insulation section 22 has a contact portion 26 which is in direct contact with the adhesive material 40. Side walls of the contact portion define side walls of further air channels 28 and recessed parts of the further insulation element 20' define top walls of the further air channels 28. In this example, each insulation section 22 comprises an outer cylindrical section 38 which extends along the respective conductor 12. In the example shown in figure 4, the outer cylindrical sections 38 are provided with annular ribs 34 which may be used for creating a seal between the insulation section 22 and a connector (not shown) attached to the respective conductor 12.

In this example, the further insulation element 20' does not comprise cavities 23, gaps 27' or grooves 27 in its insulation sections 22. Thus, the inner wall 25 of the conductor opening 24 only forms a mechanical seal between the conductor 12 and the insulation section 22. The insulation sections 22 are not adhered to the conductors 12. Of course, the insulation sections 22 of the further insulation element 20 could comprise cavities, gaps and/or grooves, especially such as described above.

In a further embodiment (not shown), the insulation element 20 and/or the further insulation element 20' may comprise three insulation elements 20, wherein each of the insulation elements 20 has a single insulation section 22.

Further details shown in figure 4 have already been described in connection with figures 1a to 3b. To avoid repetition, reference is made to explanations given above.

Figure 5 shows a top view of the insulation element 20 of a further exemplary embodiment of the electrical feedthrough assembly 1. The insulation element 20 of the exemplary embodiment has three insulation sections 22. In another embodiment, the insulation element 20 may comprise a different number of insulation sections 22.

The insulation element 20 as depicted in figure 4 is configured as a single piece made from an electrical insulating material. The insulation element 20 may be obtained as a mold part, for example by means of injection molding.

Each insulation section 22 has a conductor opening 24 having an inner wall 25. In the inner wall 25 grooves 27 (in this example four grooves) are provided leading into a cavity provided inside of each insulation section 22. Here, the grooves 27 are evenly distributed around the opening 24 for enabling an even ventilation during attaching the insulation element 20 to the feedthroughs of the assembly.

Of course, different numbers, shapes, dimensions and arrangements of grooves are conceivable and advantageous. Between the grooves 27 sections of the inner wall 25 remain and form ribs 29.

When the insulation section 22 is placed on the conductor the ribs 29 touch the conductor surface where no groove 27 is present. The ribs 29 serve for positioning and sealing. The grooves 27 connect the cavity 23 inside the insulation section 22 with the surrounding environment and enables gas, e.g. air, trapped in the cavity and/or in the adhesive material 40 to escape during the attachment of the insulation element 20 to the feedthrough assembly. Further, the fill level of the adhesive material inside the cavity can be monitored via at least one groove 27, and the at least one groove 27 may provide a reservoir for receiving any excess adhesive material after the cavity has been completely filled.

Figure 6 shows another exemplary embodiment of the electrical feedthrough assembly 1 having at least two grooves 27 wherein the inner wall 25 of the conductor opening touches the conductor surface outside the grooves 27 for positioning and providing a seal (not shown). The feedthrough assembly 1 of this exemplary embodiment is similar to the first exemplary embodiment described with respect to figures 1a and 1b except for especially the configuration of the fixation material 16. Instead of a flat arrangement, the fixation material 16 here forms a protrusion / glass protrusion 17 surrounding the conductor 12 and extending beyond base body 10 into cavity 23 of the insulation section 22. In general, a glass protrusion is preferably an extending portion of the fixation material, i.e. an integral part of the fixation material. In this embodiment, the glass protrusion 17 is designed as a glass meniscus, here an arc shaped glass meniscus. The glass protrusion 17 has a diameter that decreases continuously from a side of the base body 10 along the conductor 12, thereby forming an arc. The glass protrusion 17 of fixation material 16 is in contact with conductor 12.

As can be seen, cavity 23 serves as a confinement for the adhesive material 40 which is confined to a space comprising an exposed surface of the fixation material 16 (including its glass protrusion 17) and portions of the surfaces the insulation element 20. Depending on the height of the glass protrusion 17 - wherein the "height" is the extension of the glass protrusion or glass meniscus measured in the direction of the longitudinal axis of the conductor - the confinement provided by cavity 23 may also include portions of the surface of the conductor 12. Cavity 23 can compensate for variations in the shape and/or volume of the glass protrusion 17 and volume of the adhesive material 40. In the embodiment shown, cavity 23 is completely filled with and also grooves 27 are filled with the adhesive material 40, so that the insulation section 22 is affixed to the fixation material 16 and adhered to the conductor 12 via adhesive material 40.

Figure 7 shows a variant of the embodiment of figure 6 in which the at least one groove 27 is not filled with adhesive material 40 comparable to the embodiment shown in figures 1a and 1b. However, cavity 23 is here only partially filled with adhesive material 40. In this variant the insulation section 22 is affixed to the fixation material 16 and its glass protrusion 17 and not to the conductor 12. There is no connection between the base body 10 and the conductor 12 via the adhesive material 40.

Generally, in view of embodiments with glass protrusions, a glass protrusion 17 formed at the other side of the base body or glass protrusions on both sides of the base body may also be possible. A glass protrusion 17 may be realized in combination with a pocket 18 or without a pocket.

Although the present invention has been described with reference to preferred examples of embodiments, it is not limited thereto but can be modified in a variety of ways.

### List of reference numerals

- 1: electrical feedthrough assembly
- 2: electrical feedthrough
- 10: base body
- 12: conductor
- 14: opening
- 16: fixation material
- 17: (glass) protrusion, preferably glass meniscus
- 18: pocket
- 19: bore hole
- 20, 20': insulation element
- 22: insulation section
- 23: cavity
- 24: conductor opening
- 25: inner wall of 24
- 26: contact portion
- 27: groove
- 27': gap
- 28: further air channel
- 29: rib
- 30: projection
- 32: slot
- 34: annular rib
- 35: step
- 36: skirt
- 37: further air channel at skirt
- 38: outer cylindrical section
- 39: inner cylindrical section of 24
- 40: adhesive material
- 50: elevated area
- 52: recessed area

## Claims

1. Electrical feedthrough assembly (1), in particular for an e-compressor, comprising a base body (10) configured for attachment to a housing and comprising at least one electrical feedthrough (2), each electrical feedthrough (2) comprising an opening (14) in the base body (10) for a conductor (12) which is fed through the opening (14) and embedded in a fixation material (16) which seals the opening (14) of the electrical feedthrough (2), wherein the electrical feedthrough assembly (1) further comprises
at least one insulation element (20, 20') made from a natural or synthetic rubber or silicone rubber being affixed to the base body (10) by means of an electrically insulating adhesive material (40),
wherein the at least one insulation element (20, 20') comprises at least one insulation section (22), wherein each electrical feedthrough (2) has an assigned insulation section (22), each insulation section (22) having a conductor opening (24) having an inner wall (25), wherein the respective conductor (12) is fed through the conductor opening (24), and
wherein the insulation element (20, 20') being configured and arranged such that between the insulation section (22) and the conductor (12) and the fixation material (16) a cavity (23) extending along the conductor (12) is formed,
**characterized in that**
- the cavity (23) is at least partially filled with the adhesive material (40) for affixing the insulation section (22), wherein the cavity serves as a confinement for the adhesive material (40),
- between the inner wall (25) of the conductor opening (24) and a surface of the conductor (12) at least one gap (27') is formed allowing access from the cavity (23) to the environment,
wherein the at least one gap (27') is realized in form of at least one groove (27) provided in the inner wall (25) of the conductor opening (24),
wherein the conductor opening (24) of the insulation section (22), through which the conductor (12) is fed, has a cylindrical section and the inner wall (25) of the cylindrical section of the conductor opening (24) outside the at least one groove (27) touches the respective conductor surface.

2. Electrical feedthrough assembly (1) according to claim 1, **characterized in that** (i) the insulation section (22) is affixed to the fixation material (16) and adhered to the conductor (12) via the adhesive material (40) or (ii) the insulation section (22) is affixed to the fixation material (16) via the adhesive material (40), wherein preferably the fixation material (16) has a protrusion (17) .

3. Electrical feedthrough assembly (1) according to claim 1 or 2, **characterized by** at least one of the following features:
- the inner wall (25) comprises 1 to 10, preferably 2 to 8, especially preferably 4 to 6 grooves (27),
- the depth of the at least one groove (27) is in the range of from 0.05 mm to 1 mm, preferably from 0.1 mm to 0.5 mm and particular preferably from 0.1 mm to 0.3 mm.

4. Electrical feedthrough assembly (1) according to claim 1 to 3, **characterized in that** several grooves (27) are provided in the inner wall (25), wherein sections between the grooves (27) form ribs (29) of the inner wall (25) for positioning and sealing.

5. Electrical feedthrough assembly (1) according to any one of claims 1 to 4, **characterized by** at least one of the following features:
- the cavity (23) completely surrounds the conductor (12),
- the cavity (23) has an outer shape that tapers in direction towards a tip of the conductor (12),
- the cavity (23) is a conical or frustoconical cavity with decreasing diameter in direction towards a tip of the conductor (12).

6. Electrical feedthrough assembly (1) according to any one of claims 1 to 5, **characterized in that** a pocket (18) for the adhesive material (40) is defined by the base body (10) and the fixation material (16), wherein the opening (14) is located within said pocket (18).

7. Electrical feedthrough assembly (1) according to any one of claims 1 to 6, **characterized in that** the insulation element (20, 20') is configured and arranged such that a contact portion (26) of each insulation section (22) is in contact with the adhesive material (40), and preferably **in that** for each insulation section (22) a further air channel (28) is formed, a top wall of the further air channel (28) being formed by the insulation element (20, 20'), the further air channel (28) completely surrounding the contact portion (26) of the respective insulation section (22).

8. Electrical feedthrough assembly (1) according to any one of claims 1 to 7, **characterized in that** the insulation element (20, 20') comprises one insulation section (22) for each electrical feedthrough (2) and is formed as a single integral element or
**in that** the electrical feedthrough assembly (1) comprises one insulation element (20, 20') for each electrical feedthrough (2), wherein each insulation element (20, 20') has one insulation section (22).

9. Electrical feedthrough assembly (1) according to any one of claims 1 to 8, **characterized in that** the base body (10) includes means for improving resistance against bending, the means being selected from
- an elevated area (50), wherein the opening (14) is located within the elevated area (50) and/or
- a pulled-up edge.

10. Electrical feedthrough assembly (1) according to any one of claims 1 to 9, wherein the base body (10), the at least one conductor (12) and the fixation material (16) form a compression seal.

11. Electrical feedthrough assembly (1) according to any one of claims 1 to 10, wherein the fixation material (16) does not extend beyond the at least one opening (14) in the base body (10) on the side facing towards the insulation element (20, 20'), or
wherein the fixation material (16) is flush with the opening (14), or
wherein the fixation material (16) extends onto the base body (10) in an area surrounding the opening (14), wherein the fixation material (16) is preferably free from a glass meniscus surrounding the conductor (12), or
wherein the fixation material (16) has a glass protrusion, preferably a glass meniscus, surrounding the conductor (12) and extending into the cavity (23).

12. Electrical feedthrough assembly (1) according to any one of claims 1 to 11, **characterized in that** the assembly (1) comprises at least one further insulation element (20') arranged on a side of the base body (10) opposite of the at least one insulation element (20).

13. Electrical feedthrough assembly (1) according, to any one of claims 1 to 12, wherein the insulation element (20, 20') is made from a fluoroelastomer, an ethylene propylene diene monomer (EPDM) rubber, a hydrogenated nitrile-butadiene rubber (HNBR) or a silicone rubber.

14. Electrical feedthrough assembly (1) according to any one of claims 1 to 13, **characterized in that** the electrical feedthrough assembly (1) is configured as an e-compressor terminal, wherein the base body (10) is configured for attachment to a housing of an e-compressor.

15. Electric compressor comprising an electrical feedthrough assembly (1), according to any one of claims 1 to 14.
